# EUROPEAN PATENT SPECIFICATION

(11) **EP 2 070 962 B1**
(45) Date of publication and mention of the grant of the patent: **18.08.2010**
(21) Application number: 07024111.2
(22) Date of filing: 12.12.2007
(51) Int. Cl.: C08G 59/14, C08G 59/38, C08G 59/62, C08L 63/02, C09K 21/14, H01L 23/14

(54) **Solid powder formulations for the preparation of resin-coated foils and their use in the manufacture of printed circuit boards**
Festpulverformulierungen für die Zubereitung von harzbeschichteten Folien und ihre Verwendung bei der Herstellung von Leiterplatten
Formulations solides de poudre pour la préparation de feuilles revêtues de résine et leur utilisation pour la fabrication de cartes de circuit imprimé

(43) Date of publication of application: 17.06.2009
(73) Proprietor: ATOTECH Deutschland GmbH, 10553 Berlin (DE)
(72) Inventor: Kress, Jürgen, 4057 Basel (CH); Tusl, Stephan, 55127 Mainz (DE); Cicchetti, Sandro, 4312 Magden (CH); Bécret, Thierry, 68730 Blotzheim (FR)
(74) Representative: Albrecht, Thomas

(56) References cited:
- EP-A- 1 640 428
- JP-A- 2000 080 251
- JP-A- 2000 344 916
- JP-A- 2002 060 587
- US-A1- 2007 088 136

## Description

### FIELD OF INVENTION

The invention relates to a solid powder formulation comprising a solid thermosetting resin composition and a resin-coated foil obtained from such a formulation, optionally reinforced, and their use in the manufacturing of printed circuit boards.

### BACKGROUND ART

For the manufacturing of printed circuit boards (PCB), thermosetting epoxy resin formulations are widely used. Due to their moderate price and good overall technical characteristics they are still the industry standard for most applications in electronics (Martin W. Jawitz (Ed.), Printed circuit board materials handbook, Mc Graw Hill, New York 1997, chapter 6). Important characteristics which make epoxies so versatile raw materials are for example high thermal stability, good copper peel strength, or low water absorption. To ensure the required flame retardancy of the finished electronic product, the epoxy resins are themselves normally formulated to become flame retardant. This can, for example, be effected by the use of brominated epoxy resins. But environmental concerns and requests from OEMs (Original Equipment Manufacturer) increasingly restrict their usage. Therefore other flame retardants based on phosphorus compounds or metal hydroxides (e. g. from Al or Mg) find application.

In order to improve the mechanical properties, reinforcements are often applied in combination with epoxy resins thus to form prepregs and laminates (Martin W. Jawitz (Ed.), Printed circuit board materials handbook, Mc Graw Hill, New York 1997, chapter 9). The reinforcement most currently used are glass fabrics. For example, prepregs are currently manufactured by impregnating glass fabrics in so called treaters in which the fabric is soaked with a solvent based solution of the epoxy resin formulation and subsequent slow evaporation of the solvent and concurrent b-staging of the resin. Owing to the low viscosity of the solution, good wetting of the glass fabric is easily achieved.

Intrinsically, solvent based processes have some serious disadvantages. The solvent itself is not part of the finished product, i. e. it acts only as a carrier medium for the solute (e. g. the epoxy resin formulation). Such a solution typically has a solid content of about 50%. That means that after the solvent served its purpose, it is evaporated which needs a lot of energy and has eventually to be disposed of, normally by incineration, i.e. about 50% of the starting material ends up as waste. This adds substantially to the investment and to the running costs of any such plant. Health, environment, safety concerns, and VOC regulations are other topics of significant concern. In addition, the equipment needed to handle the solvent loaded waste air and the detectors to prevent explosive atmospheres make such a coating line complex and expensive. The rather time consuming processes of releasing the solvents and afterwards re-levelling of the surface are inherently slow and less efficient than just melting and levelling a powder matrix. Furthermore, intermediate and final products are guaranteed to be solvent free when powder coatings are employed, even when fast curing systems are used. In the light of that, a high throughput with relatively compact coating lines can be achieved. On the other hand there are the stringent requirements of base materials used in the printed circuit board industry. Especially ultra thin prepregs or resin coated foils intended for the production of high density interconnect layers (HDI layers) must cope with extensive OEM specifications which are far beyond what is expected from ordinary powder coating applications. Good solder shock resistance which is vital to pass numerous lead free solder reflow cycles requires outstanding thermal robustness. A low water uptake is needed to meet JEDEC (Joint Electron Device Engineering Council) requirements (Reference for JEDEC requirement, numerous lead free solder shock tests, and CAF resistance). A low melt viscosity allows the perfect impregnation of woven glass fibres which is essential for the material to have resistance to conductive anodic filament growth (CAF-resistance). All these properties have to be maintained in the presence of the halogen free flame retardant agent which is required to reach sufficiently low UL-V0 burning times.

Most of the used thermosetting resin compositions for the impregnation of glass fabrics and for the coating of substrates used in the PCB industry are diluted in organic solvents as well as the majority of the applied commodities. All applicable halogen free flame retardant agents are either diluted or liquid phosphorus containing components or solid additives without the potential to react into the thermosetting epoxy resin matrix. Another possibility would be the use of metal hydroxides but an unacceptable high loading of such fillers is needed. In general all of these fillers deteriorate mechanical and others properties to a significant degree. High filler loadings also lead to an strong increase of the melt viscosity and thus to a reduced ability of wetting the fibres. Therefore it would be desirable to have an epoxy resin formulation based on 100% solid content which has the capacity to impregnate and wet a glass cloth. That solid resin formulation could be made as a powder and applied as such.

The overall solid resin formulation must meet several boundary conditions. The Tg of the composition in the uncured stage (A-stage) must be high enough so that the various processing steps which are necessary to make a powder (extrusion, milling, classifying, sieving) can be executed. In the case of a Tg too low, agglutination could occur. At the same time the melt viscosity of the composition at elevated temperature must be low enough to allow for the proper impregnation of the glass cloth by the resin. Furthermore, outstanding thermal resistance, UL-V0 burning performance without using halogenated components, a low water uptake, and excellent copper adhesion are crucial parameters to fulfil typical requirements for base materials used in PCB applications.

WO 2004/085550 A2 relates to a powder coating, an aqueous dispersion based on the powder coating, a process for its preparation and a process for the preparation of coating layers on substrates, inter alia for the preparation of multilayer structures. The process does not require the use of any organic solvent.

US 2007/0088136 A1 describes a flame-retarding epoxy resin composition containing no halogen, which comprises an epoxy resin containing no halogen, a toughening agent, and a flame-retarding agent. The flame-retarding epoxy resin composition exhibits a high heat-resistance and excellent adhesion and is useful as adhesive agent in flexible printed circuit board.

JP 2002 060587 A describes a flame-retardant epoxy resin composition and prepreg, laminated sheet and printed wiring board using the same. The resin composition comprises a bisphenol F type epoxy resin, a tri- or a polyfunctional epoxy resin and a phosphorous-containing epoxy resin, rubber elastic fine particles incompatible with the epoxy resins and a novolak resin of phenols and the novolak resin of the phenols containing nitrogen atoms present in the molecular structure thereof as a curing agent.

EP 1 640 428 A1 describes an adhesive composition for semiconductor devices which comprises an epoxy resin, a phenoxy resin, and a hardener, wherein part or all of the epoxy resin comprises at least one type of epoxy resin selected from (a) a dimer acid modified epoxy resin and (b) a phosphorus containing epoxy resin having an epoxy equivalent of 2000 to 6000. The adhesive composition can suitably be used for cover layer films, adhesive sheets and copper-clad polyimide films.

### SUMMARY OF INVENTION

It is the object underlying the present invention to provide a powder coating composition enabling a fast curing at low melt viscosity but still high Tg of the powder (above 50°C). The composition should be useful in the preparation of flame retardant resin-coated foils wherein the flame retardant should not have a negative impact on the curing mechanism. Further, it is the object of the invention to provide a composition exhibiting a high copper peel strength, improved shelf life and good process characteristics like higher throughput in the milling process. The composition must be capable to successfully impregnate a glass fabric in a subsequent lamination step without the formation of voids, wetting defects, air bubbles and the like.

According to the present invention this object is achieved by a powder formulation comprising a thermosetting resin composition comprising the following components:
(A) an epoxy resin solid at ambient temperature (20°C),
(B) a solid (at ambient temperature (20°C)) phenolic hardener having an average functionality > 3, preferably > 5, more preferably > 7 and most preferred ≥ 9,
(C) a solid (at ambient temperature (20°C)) phosphorous-modified epoxy resin and
(D) a latent catalyst, which is a substituted urea or urone-type catalyst.

### DESCRIPTION OF INVENTION

Component (A) is preferably a chemically modified epoxy resin having an epoxy equivalent weight (EEW) ranging from 150 to 1800 g/eq.

Such a chemically modified epoxy resin includes isocyanate modified epoxy resins, butadiene-acrylnitrile rubber-modified epoxy resins, multifunctional epoxy-phenol novolak resins and bisphenol-A based or cyclo-aliphatic epoxy resins.

Suitable solid hardeners (B) for use in the present invention are selected from the group consisting of phenol novolak resins, cresol novolak resins and bisphenol A novolak resins, which do not have any epoxy groups like the hardeners described in WO 2004/085550 A2.

According to a preferred embodiment of the invention, the solid hardener (B) is a phenolic novolak resin having an average functionality of at least 9, wherein average functionality denotes the average number of functional groups (-OH) per molecule. Such solid hardeners include, for example, TD 2131 (available from Dainippon Ink & Chemicals Inc.) and PF 0790 K04 (available from Hexion).

Component (C) is a solid phosphorous-modified epoxy resin selected from, for example, the group consisting of DOPO (Di-hydro-9-oxa-10-phosphaphenantrene-10-oxide)-modified multifunctional epoxy phenol or cresol novolak resins and DOPO-HQ 2-(6-Oxo-6H-6,5-dibenzo[c,e] [1,2] oxaphosphine-6-yl)benzene-1,4-diol) modified bi-functional epoxy resins. Additionally, Struktol VP 3752 (available from Schill + Seilacher) and EXA 9726 (available from Dainippon Ink & Chemicals Inc.) may be mentioned. EXA 9726 basically corresponds to EXA 9710 which is a solution of EXA 9726 in an organic solvent (MEK, acetone).

Further suitable solid phosphorous-modified epoxy resins for use in the present invention are described in United States patent application publication No. US 2006/0223921 A1. This document discloses a prepolymer for flame resistant polymers which is obtained by reacting at least one phosphinic acid derivative of formula I

(R¹O)(R²)P(O)-R³,

wherein R¹ and R² independently of one another represent an optionally substituted alkyl, aryl, arylalkyl, alkylaryl or alkylarylalkyl group with 1 to 20 carbon atoms,
R³ represents hydrogen or an optionally substituted alkyl, aryl, arylalkyl, alkylaryl or alkylarylalkyl group with 1 to 20 carbon atoms,
with, for example, an epoxy resin.

Further, suitable phosphorous-modified epoxy resins for use in the present invention are described in Japanese patent application publication No. JP 2000080251.

According to a preferred embodiment of the invention, the solid phosphorous modified epoxy resin is a bifunctional epoxy resin having an EEW less than 500 g/eq and a phosphorous content more than 2% by weight.

Component (D) is a latent catalyst. Said latent catalyst is at ambient temperature chemically blocked and the catalytically active component is generated at elevated temperature > 120°C, such as Dyhard^{®} UR 300 and Dyhard^{®} UR 500 (available from Degussa).

The latent catalyst (D) is a substituted urea catalyst or an urone-type catalyst. Such substituted urea catalysts have the general chemical structure 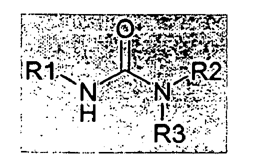 wherein R1 denotes a substituted or unsubstituted phenyl group and wherein R2 and R3, which may be the same or different, are selected from linear or branched alkyl groups having 1 to 6 carbon atoms.

Quatemisation of such substituted urea catalysts results in urone-type catalysts having the formula [R¹R²N-C(OR³)=NR⁴R⁵]⁺X⁻ (wherein R¹ to R⁵ are selected from hydrogen or organic residues and X⁻ is an acid anion).

A suitable urone-type catalyst for use in the present invention is, for example, URAcc 43 (available from Degussa).

The thermosetting resin composition may optionally further comprise an inorganic filler (E). Such inorganic fillers include SiO₂, Al₂O₃, AlOOH, kaolin and talc.

Preferably, the average particle size of the inorganic filler is less than 5 micron.

While the composition of the powder formulation may vary depending on the desired physical characteristics, it generally comprises components (A) to (D) and, optionally, component (E) in the amounts specified below:
(i) 25-50% by weight and preferably 35-45% by weight of component (A),
(ii) 15-25% by weight of component (B),
(iii) 15-25% by weight of component (C),
(iv) 0.05-1 % by weight of component (D),
(v) 0-40%by weight and preferably 20-30% by weight of component (E).

For example, a preferred composition comprises 35 to 45% of an epoxy resin selected from the following: XAC 4151 (available from Asahi Kasei), AER 4151 (available from Asahi Kasei), EPPN 502H (available from Nippon Kayaku), Hypox RK84L (available from CVC) and mixtures thereof. A preferred embodiment of component (A) consists of all of the aforementioned four epoxy resins.

A suitable hardener (B) for use with such epoxy mixtures is PF 0790 K04 (available from Hexion).

According to a preferred embodiment of the invention, EXA 9726 (available from Dainippon Ink & Chemicals Inc.) is used as phosphorous-modified epoxy resin.

Preferably, URAcc 43 (available from Degussa) is used as a latent catalyst with the above mixtures.

A particularly preferred powder formulation comprises XAC 4151 (available from Asahi Kasei), AER 4151 (available from Asahi Kasei), EPPN 502H (available from Nippon Kayaku), Hypox RK84L (available from CVC), PF 0790 K04 (available from Hexion), EXA 9726 (available form Dainippon Ink & Chemicals Inc.) and URAcc 43 (available from Degussa) in the amounts (i) to (iv) specified above.

The compositions according to the present invention feature a high latency and a high glass transition temperature after curing.

In the present invention latency is defined as follows:
Latency [°K] = Exothermal Peak Temperature [°C] - Exothermal Onset Temperature [°C] as determined by differential scanning calorimetry (DSC).

Thus, a lower value for latency (spread from onset to peak temperature) means a narrower reaction heat peak and therewith a more latent curing mechanism, especially if the onset temperature is above 150°C and the peak temperature is below 180°C. A wider enthalpy peak means a declined shelf life and no fast cure- ability.

A high glass transition temperature (Tg) after curing is desirable in that application because many of the physical properties deteriorate around the glass transition temperature, e.g. reduced stiffness and increased thermal expansion.

As will be explained below, the compositions according to the present invention achieve the desired high latency and the high Tg after curing by combination of catalyst (D) and hardener (B). In other words, this combination of the hardener and, in particular, a hardener having an average functionality of > 3, preferably > 5, more preferably > 7 and most preferred ≥ 9 and a latent catalyst and, in particular, a substituted urea or urone-type catalyst performs considerably better than prior art thermosetting epoxy resin compositions.

Preferably, the compositions according to the present invention have a latency, measured as spread from onset temperature to peak temperature, below 20K. Preferably the onset temperature ranges from 140-160°C and the peak temperature shall be below 180°C.

After curing, the compositions preferably have a Tg ranging from 150-160°C.

Another important feature of the compositions according to the present invention is their improved shelf life and their fast curing ability. Both items are important for the handling and processing of the resin compositions used to prepare resin-coated foils. In the compositions according to the present invention there is no relevant curing below 120°C, but rather fast curing occurs at elevated temperatures above 150°C. At a temperature of 160°C, the formulations can be fully cured within 30 minutes and at 170°C only 15 minutes baking time is sufficient for full cure.

The shelf life of the compositions according to the present invention is demonstrated by their loss in reaction enthalpy which is less than 15%. It does not lead to significant changes in melt viscosity and slow characteristics. If the compositions according to the present inventions are stored at temperatures less than 6°C, no changes in reaction heat were observed.

In view of their improved shelf life, it is possible to store the powder formulation according to the present invention for more than six months.

The compositions according to the present invention also exhibit an improved flame retardancy as far as the amount of flame retardants and their effects on the curing mechanism are concerned. Thus, the flame retardant has a chemical structure similar to the epoxy resin used as component (A) in the compositions according to the present invention, except for comprising phosphorous as an additional element. Therefore, it is incorporated into the backbone structure obtained by curing the thermosetting resin composition, which incorporation results in a lower concentration of flame retardant to achieve VO ratings when compared to the use of conventional flame retardants known in the prior art. In addition, in view of its structural similarity, the flame retardant does not adversely affect the curing mechanism by which the compositions are thermoset, since the flame retardant becomes part of the crosslinked product.

A particularly preferred solid phosphorous-modified epoxy resin for use in the present invention is the polyaddition product of 2-(6-Oxo-6H-6,5-dibenzo[c,e] [1,2] oxaphosphine-6-yl)benzene-1,4-diol) with (the product of etherification of phenol/formaldehyde polycondensation and 1-chloro-2,3-epoxypropane). The structure of such DOPO modified multifunctional epoxy phenol novolak resins is shown below:

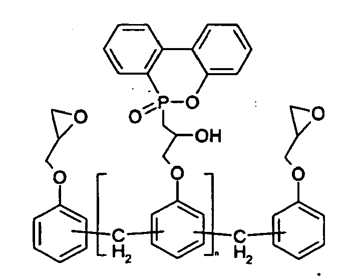

Other particularly preferred solid phosphorous-modified epoxy resins for use in the present invention are HCA-HQ modified difunctional bisphenol A epoxy resins as shown below:

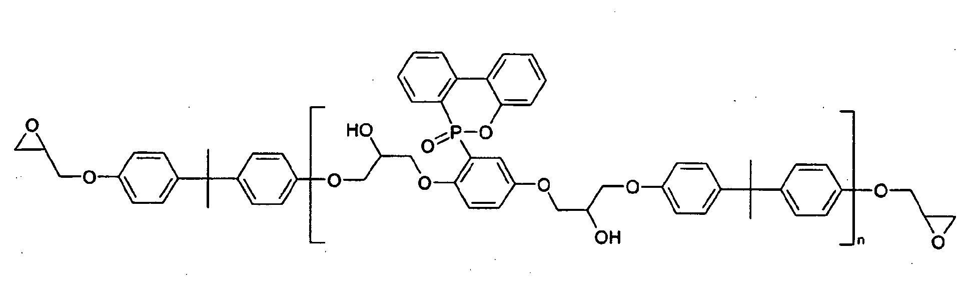

The preparation of the above mentioned epoxy resins is described in Japanese patent application publication No. JP 2000080251 and United States patent application publication No. US 2006/0223921 A1.

The solid phosphorous-modified epoxy resin reduces the total burning time of the samples tested significantly. At the same time, the samples exhibited an excellent copper peel strength when compared to samples comprising a conventional phosphorous flame retardant agent.

In summary, the compositions according to the present invention have improved physical properties qualifying them for their use for the preparation of resin coated foils which, in their turn, can be used in the manufacture of printed circuit boards. In particular, the powder formulations comprising the thermosetting resin composition as described hereinbefore have the following physical properties:
(i) a glass transition temperature in the non-converted A-stage greater than 50°C as determined by DSC,
(ii) a melt viscosity of less than 20 Pas at 140°C,
(iii) a glass transition temperature of >150°C after curing at 190°C for 20 minutes as determined by DSC,
(iv) a decomposition temperature greater than 390°C at 1% weigh loss determined by thermogravimetric analysis (TGA) and
(v) a dielectric constant (Dk) of < 3.4 and a dissipation factor (Df) of < 0.018 measured at 1 GHz.

The present invention further provides a resin-coated foil obtainable by coating a substrate with the powder formulation as described hereinabove to obtain a coated substrate and thermally fixing the powder formulation at elevated temperatures, such as 150°C and above, to the substrate to obtain a resin-coated foil.

Suitable substrates for use in such a coating process are selected from metal foils e.g. copper, aluminium or nickel as well as polymeric foils withstanding elevated temperature exposure at the desired level to melt the described thermosetting resin composition.

Preferably, the resin-coated foil comprises reinforcements, preferably those used to form prepregs or laminates. Such reinforcements include fabric cloth and glass cloth.

Thus, the present invention further provides a resin-coated foil which is reinforced with E-glass cloth, for example, and clad with a metal such as electrodeposited copper.

Such a reinforced resin-coated foil resists delamination for more than 30 minutes when subjected to the delamination test according to IPC TM 650 2.4.24.1. In addition, it shows a copper peel strength of greater than 17 N/cm at a 35 micron copper thickness in the test according to IPC TM 650 2.4.8 C.

After removal of the copper cladding, such a laminate construction as described above resists the solder dip test at 288°C for 20 seconds after boiling it in a high pressure cooker vessel for 30 minutes at 2.6 bar (which corresponds to 140°C) such that low delamination or blistering is observed in the test according to IPC TM 650 2.6.16. The 40 micron thick film shows a water uptake of less than 1% in the test according to IPC TM 650 2.6.2 C.

When tested in the vertical UL-burning test, the glass cloth reinforced film gets a V0 rating either pressed on a 200 micron thick FR4 core up to a supplementary thickness of 240 micron (corresponds to 6 plies) respectively pressed as bare laminate to a thickness of 160 micron (corresponds to 4 plies) in the absence of halogenated components.

Compounding of claimed thermosetting resin composition can be done by an extruder whereas the gently incorporation of the catalyst C is a vital parameter to maintain the said latency. A chill belt and cooled rollers shall cool reduce the temperature of the melt so that it can eventually be crushed into flakes.

The powder is made from the said flakes by milling e.g. with an impact mill or air jet mill. If required by the subsequent coating processes a classifier can be used to remove the fines from the powder. The average particle size can thus be adjusted to the desired value.

The powder can be applied on a substrate e.g. metal foil as mentioned above to be thermally fixed at elevated temperature to the substrate.

### BRIEF DESCRIPTION OF THE DRAWINGS

Fig. 1 shows a DSC scan of a powder formulation according to the present invention and a comparative formulation.
Fig. 2 shows the curing speed expressed in % conversion of the compositions according to the present invention at various temperatures.

The invention is further illustrated by the following examples. In these examples, the majority of the performed test methods are related to the IPC TM650 (Association Connecting Electronic Industries). This manual establishes uniform methods for testing electronic and electrical parts including basic environmental, physical and electrical tests. These tests were developed to support IPC standards and specifications (IPC TM650 (Association Connecting Electronic Industries) 2215 Sanders Road, Northbrook, IL 60062-6135).

More particularly, the parameters mentioned below were tested as follows:
(a) The glass transition temperature (Tg) after curing was determined according to IPC TM 650 2.4.25 C.
(b) The gel time was determined according to IPC TM 650 2.3.18 A.
(c) The time to delamination (TMA method) was determined according to IPC TM 650 2.4.24.1.
(d) Viscosity was measured by using a cone plate configuration with an angle of 2° and a rotation speed of 5 rpm. The temperature was set to 140°C (+/-0.5K).
(e) HPCT was determined according to test method IPC TM 650 2.6.16.
(f) The peel strength was determined according to IPC TM 650 2.4.9.
(g) The total burning time (per sample) was determined according to IPC TM 650 UL.
(h) The water uptake was determined according to IPC TM 650 2.6.2.1.

### Example 1

The following components were used to prepare thermosetting resin compositions:
Hardener A: Phenol novolak resin average functionality ≥ 9 (component B)
Hardener B: Phenol novolak resin average functionality < 3
Catalyst 1: Imidazole derivative (e.g. 2- Phenylimidazole Curezol 2-PZ available from Shikoku Co. Ltd.)
Catalyst 2: substituted urea catalyst (component D)

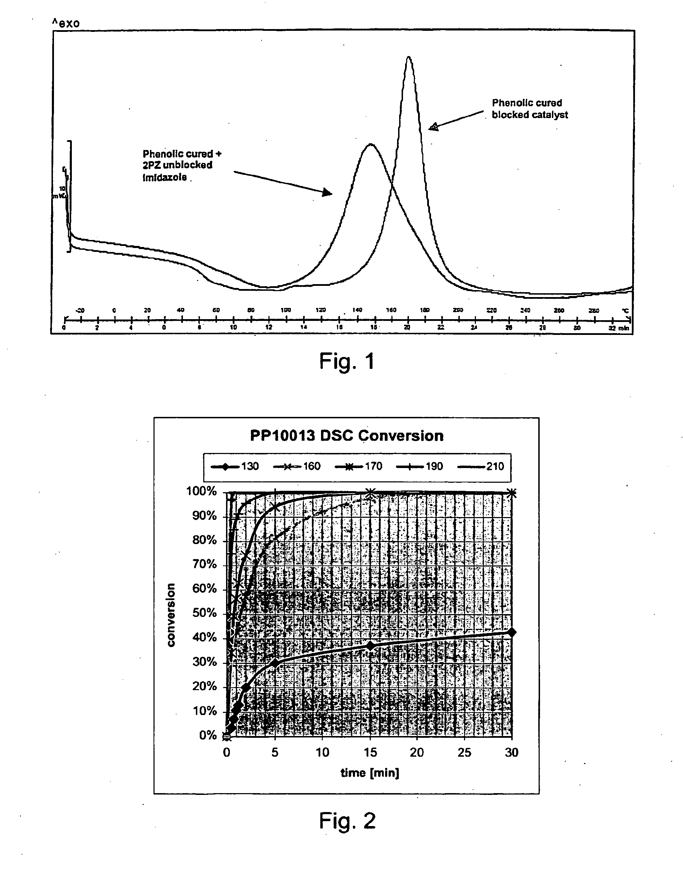

The formulations shown in table 1 were mixed at elevated temperature and then investigated by differential scanning calorimetry (DSC) in the temperature range from -30°C to 300°C in order to detect the reaction enthalpy and glass transition temperature after curing. A typical DSC scan is shown in Fig. 1.

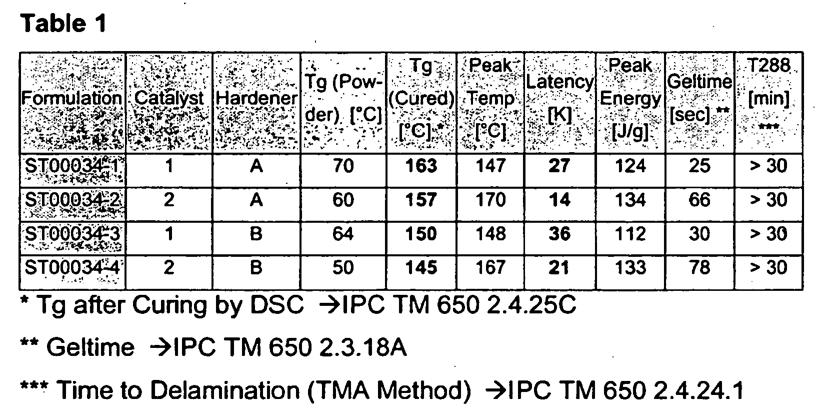

The said isocyanate modified epoxy resin made the backbone for this investigation. The hardener amounts were set to the stoichiometrical ratio. The catalyst level was 0.8% by weight for all formulations.

**ST00034-1**

| **Component** | **Amount [g]** | **Equivalent** |
|---|---|---|
| XAC 4151 | 10.00 | 78.7% |
| PF0790 K04 | 2.60 | 20.5% |
| 2PZ | 0.10 | 0.8% |

**ST00034-2**

| **Component** | **Amount [g]** | **Equivalent** |
|---|---|---|
| XAC 4151 | 10.00 | 78.7% |
| PF0790 K04 | 2.60 | 20.5% |
| URAcc 43 | 0.10 | 0.8% |

**ST00034-3**

| **Component** | **Amount [g]** | **Equivalent** |
|---|---|---|
| XAC 4151 | 10.00 | 79.4% |
| TD2131 | 2.50 | 19.8% |
| 2PZ | 0.10 | 0.8% |

**ST00034-4**

| **Component** | **Amount [g]** | **Equivalent** |
|---|---|---|
| XAC 4151 | 10.00 | 79.4% |
| TD2131 | 2.50 | 19.8% |
| URAcc 43 | 0.10 | 0.8% |

The values in Table 1 proof that just the correct combination of catalyst and curing agent performs well in both the desired low latency and the high Tg after curing. The combination of a high functionality of the hardener and a urone-type catalyst (formulation ST00034-2) is performing considerably better than the other comparative examples (formulations ST00034-1, ST00034-3 and ST00034-4).

### Example 2

The shelf life and the curing ability of the formulations described below were tested as follows:
The loss in reaction enthalpy was used to verify the shelf life of the fully formulated powder. Straight after manufacturing the reaction enthalpy was determined and taken as reference. Then the powder was stored at ambient temperature < 23°C to be tested after three and six months again. The curing conditions were tested via DSC. The specimens were exposed to varying temperatures and times inside the DSC measuring cell. After exposure the remaining reaction enthalpy was detected and taken as degree of conversion.

As shown in Fig. 2 there is no relevant curing below 120°C but rather fast curing speed at elevated temperatures above 150°C. At a temperature of 160°C the formulation can be fully cured within 30 minutes, at 170°C only 15 minutes baking time is sufficient for full cure.

In Table 2 the loss in reaction enthalpy is shown in order to demonstrate the shelf life of several formulations (different epoxy resin combinations) all cured with the claimed combination of phenolic hardener and blocked catalyst. Typically a reduction of reaction enthalpy below 15% is tolerable and does not lead to significant changes in melt viscosity and flow characteristics. If the formulation is stored at temperatures ≤ 6°C no changes in reaction heat were observed.

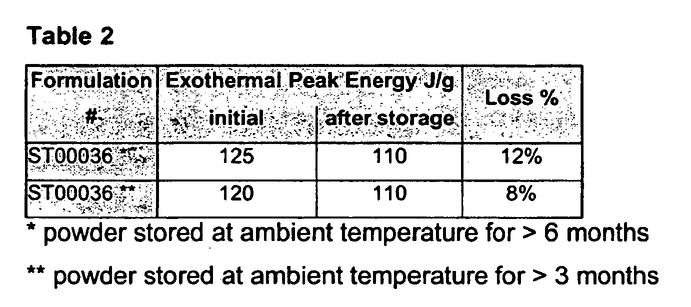

### Formulation Details

ST00036 : comprising said isocynate modified epoxy resins, phenol novolak hardener (B), inorganic filler (E) and substituted urea catalyst (D)

| **Component** | **parts by** **weight** | **wt%** |
|---|---|---|
| XAC 4151 | 200.00 | 32.00 |
| AER 4152 | 200.00 | 32.00 |
| Silbond * | 100.00 | 16.00 |
| PF0790K04 | 116.00 | 18.56 |
| Epon 1031 ** | 6.00 | 0.96 |
| URAcc43 | 3.00 | 0.48 |
| **Total** | **625.00** | **100.00** |

| | | |
|---|---|---|
| * Silbond is a SiO₂ filler available from Quarzwerke ** Epon 1031 is a solid multifunctional epichlorohydrine/tetraphenylol ethane epoxy resin available from Hexion (in parts UV blocking) | | |

### Example 3

Formulation ST00036 described in Example 2 was used as reference and the below mentioned phosphor sources were added in a ratio desired to have a total phosphor content of 1% by weight.

The phosphorous content, the melting point and the chemical structure of the flame retardants used is shown in Table 3 below.

The list contains only potential phosphorus sources which are by their nature applicable in powder formulations, e.g. having a melting point >50 °C.

**Table 3**

| **Component No.** | **Phosphorus content** | **Melting Point** | **Chemical structure** |
|---|---|---|---|
| 1) Sanko HCA (DOPO) Di-hydro-9-oxa-10-phospphaphenantrene-10-oxide | 14% | 118°C | 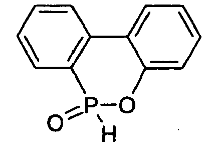 |
| 2) Sanko HCA-HQ (DOPO-derivate) Di-hydro-9-oxa-10-phosphaphenantrene-10-oxide-benzendiol | 9.5% | 250°C | 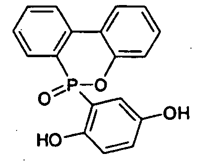 |
| 3) Dow XZ 92588 | n.a. | 86°C | Phosphorus containing phenolic co-hardener |
| 4) Component C | > 2% | 89°C | Phosphor modified di-functional epoxy resin (EXA 9726) |
| 5) Polydis Struktol 3780 | 8% | 70°C | DOPO modified polyester resin |

All tested phosphorus sources were efficient and reduced the total burning time significantly. The best overall performance was reached with component C. The free DOPO containing formulation performed very poor concerning T288 resistance and copper peel strength. The DOPO derivate HCA-HQ was much better but remaining (non converted) particles were observed. This is most likely due to the high melting point of the component. Also the component XZ 92588 reduced the copper peel strength considerably. See results table 4. The reference ST00036 does not contain any flame retardant.

**Table 4**

| Formulation | ST00036 | ST00037 | ST00040 | ST00047 | S700053 | ST00066 | Unit | IPC TM- 650-Test Method |
|---|---|---|---|---|---|---|---|---|
| Content | | | | | | | | |
| Component No. | Reference | 3) | 1) | 2) | 5) | 4) | | |
| Thermal Powder | | | | | | | | |
| Tg before curing (DSC DIN Mid Point) | 53 | 54 | 44 | 49 | 50/73 | 52 | °C | |
| T_{g} after curing (DSC Din Mid Point) | 156 | 136 | 135 | 154 | 128 | 150 | °C | |
| Exothermal Peak Temperature | 176 | 179 | 178 | 174 | 177 | 176 | °C | |
| Exothermal Peak Energy | 125 | 96 | 141 | 118 | 104 | 140 | J/g | |
| Geltime @ 180°C [s] | 89 | 174 | 152 | 91 | 120 | 77 | | |
| Mechanical Powder Powder | | | | | | | | |
| Rheology: Min viscosity Pas | 16 | 31 | 8 | 29 | 39 | 18 | Pas | |
| Thermal R-RCF* | | | | | | | | |
| Time to delamination T288 (sandwich) Reference | > 30 | > 30 | 3.7 | >30 | > 30 | > 30 | min_°C | 2.4.24.1 |
| Time to delamination T288 (sandwich) after 24h @ 50% rel. H + 23°C | > 30 | > 30 | 2.6 | >30 | > 30 | > 30 | min_°C | 2.4.24.1 |
| High pressure cocker- test | pass | pass | pass | pass | pass | pass | pass / fail | 2.6.16 |
| Mechanical R-RCF* | | | | | | | | |
| Peel strength (with 35µm Cu) | 18.3 | 13.6 | 10.7 | 18.6 | 16 | 17.3 | N/cm | 1 2.4.9 |
| Chemical R-RCF* | | | | | | | | |
| Total burning time (per sample) | 6.2 | 4.2 | 4.4 | 4.6 | 4.8 | 4.2 | sec | UL |
| H2O uptake | 0.9 | 0.8 | 0.9 | 1 | 1.1 | 0.8 | % | 2.6.2.1 |

| | | | | | | | | |
|---|---|---|---|---|---|---|---|---|
| * specimen pressed as glass cloth reinforced resin coated copper foil (R-RCF) | | | | | | | | |

In summary, the present invention provides a powder coating composition comprising epoxy resins, solid hardeners, a phosphorous-containing difunctional flame retardant which has a structure similar to the aforementioned epoxy resins, a latent catalyst, particularly an urea catalyst and optionally an inorganic filler. The combination of such hardeners and catalysts enables a fast curing at low melt viscosity but still high Tg of the powder (above 50°C). The phosphorous-containing flame retardant becomes part of the resin backbone. It can be used in small amounts compared to hitherto used flame retardants and does not have a negative impact on the curing mechanism.

The composition according to the present invention exhibits a higher copper peel strength, improved shelf life and good process characteristics like higher throughput in the milling process.

## Claims

1. A powder formulation comprising a thermosetting resin composition comprising the following components:
(A) an epoxy resin solid at 20°C,
(B) a phenolic hardener solid at 20°C having an average functionality > 3,
(C) a phosphorous-modified epoxy resin solid at 20°C and
(D) a latent catalyst,
wherein the latent catalyst (D) is a substituted urea or urone-type catalyst.

2. The powder formulation according to claim 1 wherein said epoxy resin (A) is a chemically modified epoxy resin having an epoxy equivalent weight ranging from 150 to 1800 g/eq.

3. The powder formulation according to claim 1 wherein said solid phenolic hardener (B) is a phenolic novolak resin having an average functionality of at least 9.

4. The powder formulation according to claim 1 wherein said solid phosphorous-modified epoxy resin (C) is a bifunctional epoxy resin having an epoxy equivalent weight less than 500 g/eq and a phosphorous content greater than 2% by weight.

5. The powder formulation according to claim 1 further comprising an inorganic filler (E).

6. The powder formulation according to claims 1 to 5 consisting essentially of
(i) 25-50% by weight of component (A),
(ii) 15-25% by weight of component (B),
(iii) 15-25% by weight of component (C),
(iv) 0.05-1% by weight of component (D),
(v) 0-40% by weight of component (E).

7. The powder formulation according to claim 6 consisting essentially of
(i) 35-45% by weight of component (A),
(ii) 15-25% by weight of component (B),
(iii) 15-25% by weight of component (C),
(iv) 0.05-1 % by weight of component (D),
(v) 20-30% by weight of component (E).

8. The powder formulation according to claim 1 or 2 wherein said epoxy resin (A) is selected from the group consisting of isocyanate-modified epoxy resins, butadiene-acrylnitrile rubber-modified epoxy resin, multifunctional epoxy-phenol novolak resin and bisphenol-A based or cyclo-aliphatic epoxy resins.

9. The powder formulation according to claim 1 or 3 wherein said solid phenolic hardener (B) is selected from the group consisting of phenol novolak resins, cresol novolak resins and bisphenol A novolak resins.

10. The powder formulation according to claim 1 or 4 wherein said solid phosphorous modified epoxy resin is the polyaddition product of 2-(6-Oxo-6H-6,5-dibenzo[c,e] [1,2] oxaphosphine-6-yl)benzene-1,4-diol) with (the product of etherification of phenol/formaldehyde polycondensation and 1-chloro-2,3-epoxypropane).

11. The powder formulation according to claim 1 wherein said latent catalyst is selected from the group of having the general chemical structure 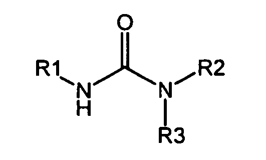 wherein R1 denotes a substituted or unsubstituted phenyl group and wherein R2 and R3, which may be the same or different, are selected from linear or branched alkyl groups having 1 to 6 carbon atoms.

12. The powder formulation according to any one of claims 1 and 5 wherein said filler is selected from the group consisting of SiO₂, Al₂O₃, AlOOH, kaolin and talc.

13. A resin-coated foil obtainable by coating a substrate with the powder formulation according to claims 1 to 12 to obtain a coated substrate and thermally fixing the powder formulation at elevated temperature of 150°C and above to the substrate to obtain a resin-coated foil.

14. The resin-coated foil according to claim 13 comprising reinforcements to form prepregs or laminates.

15. The resin-coated foil according to claim 14 wherein said reinforcements are selected from the group consisting of fabric cloth and glass cloth.

16. The resin-coated foil according to claim 15 which is reinforced with E-glass cloth and clad with electrodeposited copper.

17. The resin-coated foil according to claim 16 having a copper peel strength determined according to IPC TM 650 2.4.8 C of more than 17 N/cm at 35 micron copper thickness and resisting delamination at 300°C for more than 30 minutes when subjected to the delamination test according to IPC TM 650 2.4.24.1.

18. The resin-coated foil according to claim 17 resisting the solder dip test according to IPC TM 650 2.6.16 at 288°C for 20 seconds after removal of the copper cladding and boiling it in an autoclave for 30 minutes.

19. The resin-coated foil according to claim 18 which is free from halogenated compounds and passes the vertical UL-burning test according to IPC TM 650 UL as VO either pressed on a 200 micron thick FR4 core up to a supplementary thickness of 240 micron corresponding to 6 plies, respectively, pressed as bare laminate to a thickness of 160 micron corresponding to 4 plies.

20. A process for the preparation of the powder formulation according to claims 1 to 12 comprising the following steps:
(i) mixing components (A) to (D) and optionally component (E),
(ii) meltextruding the mixture obtained in step (i) and
(iii) milling and sieving the extruded mixture.

21. Use of the resin-coated foil according to claims 13 to 19 in the manufacture of printed circuit boards.

## Patentansprüche

1. Pulverformulierung, umfassend eine thermohärtende Harzzusammensetzung, umfassend die folgenden Komponenten:
(A) ein bei 20°C festes Epoxyharz,
(B) einen bei 20°C festen phenolischen Härter mit einer durchschnittlichen Funktionalität > 3,
(C) ein bei 20°C festes Phosphor-modifiziertes Epoxyharz und
(D) einen latenten Katalysator,
wobei der latente Katalysator (D) ein Katalysator vom substituierten Harnstoff- oder Uron-Typ ist.

2. Pulverformulierung gemäß Anspruch 1, wobei das Epoxyharz (A) ein chemisch modifiziertes Epoxyharz mit einem Epoxyäquivalentgewicht, das von 150 bis 1800 g/eq reicht, ist.

3. Pulverformulierung gemäß Anspruch 1, wobei der feste phenolische Härter (B) ein phenolisches Novolakharz mit einer durchschnittlichen Funktionalität von mindestens 9 ist.

4. Pulverformulierung gemäß Anspruch 1, wobei das feste Phosphor-modifizierte Epoxyharz (C) ein bifunktionelles Epoxyharz mit einem Epoxyäquivalentgewicht von weniger als 500 g/eq und einem Phosphorgehalt größer als 2 Gew.-% ist.

5. Pulverformulierung gemäß Anspruch 1, des weiteren umfassend einen anorganischen Füllstoff (E).

6. Pulverformulierung gemäß Ansprüchen 1 bis 5, im Wesentlichen bestehend aus
(i) 25-50 Gew.-% Komponente (A),
(ii) 15-25 Gew.-% Komponente (B),
(iii) 15-25 Gew.-% Komponente (C),
(iv) 0,05-1 Gew.-% Komponente (D),
(v) 0-40 Gew.-% Komponente (E).

7. Pulverformulierung gemäß Anspruch 6, im Wesentlichen bestehend aus
(i) 35-45 Gew.-% Komponente (A),
(ii) 15-25 Gew.-% Komponente (B),
(iii) 15-25 Gew.-% Komponente (C),
(iv) 0,05-1 Gew.-% Komponente (D),
(v) 20-30 Gew.-% Komponente (E).

8. Pulverformulierung gemäß Anspruch 1 oder 2, wobei das genannte Epoxyharz (A) ausgewählt ist aus der Gruppe, bestehend aus Isocyanat-modifizierten Epoxyharzen, Butadienacrylnitrilkautschuk-modifiziertem Epoxyharz, multifunktionellem Epoxy-Phenol-Novolakharz und Bisphenol-A-basierten oder cycloaliphatischen Epoxyharzen.

9. Pulverformulierung gemäß Anspruch 1 oder 3, wobei der feste phenolische Härter (B) ausgewählt ist aus der Gruppe, bestehend aus Phenolnovolakharzen, Cresolnovolakharzen und Bisphenol-A-Novolakharzen.

10. Pulverformulierung gemäß Anspruch 1 oder 4, wobei das feste Phosphor-modifizierte Epoxyharz das Polyadditionsprodukt von 2-(6-Oxo-6H-6,5-dibenzo[c,e][1,2]oxaphosphin-6-yl)benzen-1,4-diol) mit (dem Produkt der Veretherung der Phenol/Formaldehyd-Polykondensation und 1-Chlor-2,3-epoxypropan) ist.

11. Pulverformulierung gemäß Anspruch 1, wobei der latente Katalysator ausgewählt ist aus der Gruppe mit der allgemeinen chemischen Struktur 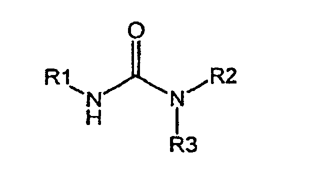 wobei R1 eine substituierte oder unsubstituierte Phenylgruppe bezeichnet, und wobei R2 und R3, welche gleich oder verschieden sein können, ausgewählt sind aus linearen und verzweigten Alkylgruppen mit 1 bis 6 Kohlenstoffatomen.

12. Pulverformulierung gemäß einem beliebigen der Ansprüche 1 und 5, wobei der genannten Füllstoff ausgewählt ist aus der Gruppe, bestehend aus SiO₂, Al₂O₃, AlOOH, Kaolin und Talk.

13. Harzbeschichtete Folie, erhältlich durch Beschichten eines Substrats mit der Pulverformulierung gemäß Ansprüchen 1 bis 12 unter Erhalt eines beschichteten Substrats und thermisches Fixieren der Pulverformulierung bei erhöhter Temperatur von 150°C und höher auf dem Substrat unter Erhalt einer harzbeschichteten Folie.

14. Harzbeschichtete Folie gemäß Anspruch 13, umfassend Verstärkungen zur Bildung von Prepregs oder Laminaten.

15. Harzbeschichtete Folie gemäß Anspruch 14, wobei die Verstärkungen ausgewählt sind aus der Gruppe, bestehend aus Vliesstoff und Glasfasergewebe.

16. Harzbeschichtete Folie gemäß Anspruch 15, welche mit E-Glasfasergewebe verstärkt ist und mit galvanischem Kupfer plattiert ist.

17. Harzbeschichtete Folie gemäß Anspruch 16 mit einer Kupferablösefestigkeit, bestimmt gemäß IPC TM 650 2.4.8 C, von mehr als 17 N/cm bei 35 Mikrometer Kupferdicke, welche einer Schichtenspaltung bei 300°C mehr als 30 Minuten widersteht, wenn sie dem Schichtenspaltungstest gemäß IPC TM 650 2.4.24.1 unterworfen wird.

18. Harzbeschichtete Folie gemäß Anspruch 17, welche dem Löt-Dip-Test gemäß IPC TM 650 2.6.16 bei 288°C für 20 Sekunden nach Entfernung der Kupferplattierung und Kochen in einem Autoklaven für 30 Minuten widersteht.

19. Harzbeschichtete Folie gemäß Anspruch 18, welche frei von halogenierten Verbindungen ist, und den vertikalen UL-Brenntest gemäß IPC TM 650 UL als VO besteht, entweder gepresst auf einen 200 Mikrometer dicken FR4-Core bis zu einer ergänzenden Dicke von 240 Mikrometer, entsprechend 6 Lagen, bzw. gepresst als reines Laminat auf eine Dicke von 160 Mikrometer entsprechend 4 Lagen.

20. Verfahren zur Herstellung einer Pulverformulierung gemäß Ansprüchen 1 bis 12, umfassend die folgenden Schritte:
(i) Mischen von Komponenten (A) bis (D), und gegebenenfalls Komponente (E),
(ii) Schmelzextrudieren der Mischung, erhalten in Schritt (i) und
(iii) Mahlen und Sieben der extrudierten Mischung.

21. Verwendung der harzbeschichteten Folie gemäß Ansprüchen 13 bis 19 in der Herstellung gedruckter Leiterplatten.

## Revendications

1. Formulation en poudre comprenant une composition de résine thermodurcissable comprenant les composants suivants :
(A) une résine époxy solide à 20°C ;
(B) un solide durcisseur phénolique à 20°C ayant une fonctionnalité moyenne > 3 ;
(C) une résine époxy solide modifiée en phosphore à 20°C ; et
(D) un catalyseur latent,
dans laquelle le catalyseur latent (D) est un catalyseur de type urée substituée ou urone.

2. Formulation en poudre selon la revendication 1, dans laquelle ladite résine époxy (A) est une résine époxy chimiquement modifiée ayant un poids d'équivalent époxy compris entre 150 et 1800 g/eq.

3. Formulation en poudre selon la revendication 1, dans laquelle ledit durcisseur phénolique solide (B) est une résine novolaque phénolique ayant une fonctionnalité moyenne d'au moins 9.

4. Formulation en poudre selon la revendication 1, dans laquelle ladite résine époxy modifiée en phosphore solide (C) est une résine époxy bifonctionnelle ayant un poids équivalent époxy inférieur à 500 g/eq et une teneur en phosphore supérieure à 2% en poids.

5. Formulation en poudre selon la revendication 1 comprenant en outre une charge inorganique (E).

6. Formulation en poudre selon les revendications 1 à 5, essentiellement constituée de
(i) 25-50% en poids de composant (A)
(ii) 15-25% en poids de composant (B)
(iii) 15-25% en poids de composant (C)
(iv) 0,05-1% en poids de composant (D)
(v) 0-40% en poids de composant (E).

7. Formulation en poudre selon la revendication 6, essentiellement constituée de
(i) 35-45% en poids de composant (A)
(ii) 15-25% en poids de composant (B)
(iii) 15-25% en poids de composant (C)
(iv) 0,05-1% en poids de composant (D)
(v) 20-30% en poids de composant (E).

8. Formulation en poudre selon la revendication 1 ou 2, dans laquelle ladite résine époxy (A) est choisie dans le groupe constitué de résines époxy modifiées en isocyanate, de résine époxy modifiée en butadiène-caoutchouc d'acrylnitrile, de résine de novolaque phénolique-époxy multifonctionnelle, et de résines époxy cyclo-aliphatiques ou à base de bisphénol A.

9. Formulation en poudre selon la revendication 1 ou 3, dans laquelle ledit durcisseur phénolique solide (B) est choisi dans le groupe constitué de résines de novolaque phénolique, de résines de novolaque de crésol et de résines de novolaque de bisphénol A.

10. Formulation en poudre selon la revendication 1 ou 4, dans laquelle ladite résine époxy modifiée en phosphore solide est le produit de la polyaddition de 2-(6-oxo-6H-6,5-dibenzo[c,e] [1,2] oxaphosphine-6-yl)benzène-1,4-diol) avec (le produit d'éthérification de phénol/polycondensation de formaldéhyde et l'1-chloro-2,3-époxypropane).

11. Formulation en poudre selon la revendication 1 dans laquelle ledit catalyseur latent est choisi dans le groupe ayant la structure chimique générale 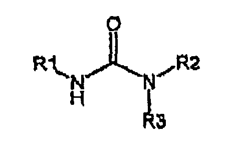 dans lequel R1 représente un groupe phényle substitué ou insubstitué et dans lequel R2 et R3, qui peuvent être identiques ou différents, sont choisis parmi des groupes alkyle linéaires ou ramifiés ayant 1 à 6 atomes de carbone.

12. Formulation en poudre selon l'une quelconque des revendications 1 et 5 dans laquelle ladite charge est choisie dans le groupe constitué de SiO₂, Al₂O₃, AlOOH, kaolin et talc.

13. Feuille revêtue de résine pouvant être obtenue en revêtant un substrat avec la formulation en poudre selon les revendications 1 à 12, afin d'obtenir un substrat revêtu et en fixant thermiquement la formulation de poudre à une température élevée de 150°C et plus, sur le substrat afin d'obtenir une feuille revêtue de résine.

14. Feuille revêtue de résine selon la revendication 13, comprenant des renforts pour former des pré-imprégnés ou des laminés.

15. Feuille revêtue de résine selon la revendication 14, dans laquelle lesdits renforts sont choisis dans le groupe constitué d'un tissu et d'un tissu de verre.

16. Feuille revêtue de résine selon la revendication 15, qui est renforcée avec un tissu en verre E et plaqué avec un cuivre électrodéposé.

17. Feuille revêtue de résine selon la revendication 16 ayant une résistance au décollement du cuivre déterminée selon la norme IPC TM 650 2.4.8.C supérieure à 17 N/cm à 35 microns d'épaisseur de cuivre et une résistance au délaminage à 300°C pendant plus de 30 minutes, quand elle est soumise au test de délaminage selon la norme IPC TM 650 2.4.24.1

18. Feuille revêtue de résine selon la revendication 17, résistant au test d'immersion de soudure selon la norme IPC TM 650 2.6.16 à 288°C pendant 20 secondes après enlèvement du plaquage de cuivre et en la faisant bouillir dans une autoclave pendant 30 minutes.

19. Feuille revêtue de résine selon la revendication 18 qui est dénuée de composés halogénés et passe le test de combustion UL vertical selon la norme IPC TM 650 UL comme VO comprimé sur une épaisseur de 200 microns de noyau FRA jusqu'à une épaisseur supplémentaire de 240 microns correspondant à 6 toiles, respectivement, comprimés comme un laminé nu à une épaisseur de 160 microns correspondant à 4 toiles.

20. Procédé pour la préparation de la formulation en poudre selon les revendications 1 à 12 comprenant les étapes suivantes :
(i) mélange des composants (A) à (D) et éventuellement du composant (E)
(ii) extrusion par fusion du mélange obtenu dans l'étape (i) et
(iii) broyage et tamisage du mélange extrudé.

21. Utilisation de la feuille revêtue de résine selon les revendications 13 à 19 dans la fabrication de cartes à circuit imprimé.
